# EUROPEAN PATENT SPECIFICATION

(11) **EP 3 627 574 B1**
(45) Date of publication and mention of the grant of the patent: **17.02.2021**
(21) Application number: 18195891.9
(22) Date of filing: 21.09.2018
(51) Int. Cl.: H01L 41/04, G01R 31/54

(54) **METHOD AND APPARATUS FOR DETECTING AN OPEN CIRCUIT STATE IN A PIEZOELECTRIC ELEMENT CONNECTION**
VERFAHREN UND VORRICHTUNG ZUR DETEKTION EINER STROMKREISUNTERBRECHUNG IM ANSCHLUSS EINES PIEZOELEKTRISCHEN ELEMENTS
PROCÉDÉ ET APPAREIL POUR DÉTECTER UN ÉTAT DE CIRCUIT OUVERT DANS UNE CONNEXION D'UN ÉLÉMENT PIÉZOÉLECTRIQUE

(43) Date of publication of application: 25.03.2020
(73) Proprietor: TE Connectivity Norge AS, 5258 Blomsterdalen (NO)
(72) Inventor: BOE, Hakon, 5081 Bergen (NO)
(74) Representative: Grünecker Patent- und Rechtsanwälte PartG mbB

(56) References cited:
- EP-A1- 2 048 343
- WO-A1-2014/074290
- DE-B3- 10 325 446
- US-A1- 2001 039 484
- US-A1- 2011 140 685

## Description

The present disclosure relates to a method and apparatus for failure detection in piezoelectric elements.

In a piezoelectric apparatus, failures such as an open circuit state can occur. To avoid further damage of the apparatus, a malfunction in the piezoelectric element must be detected quickly. To that end, devices for detecting a failure in a piezoelectric apparatus have been suggested (see e.g. US 5376854, CN 105675960 A).

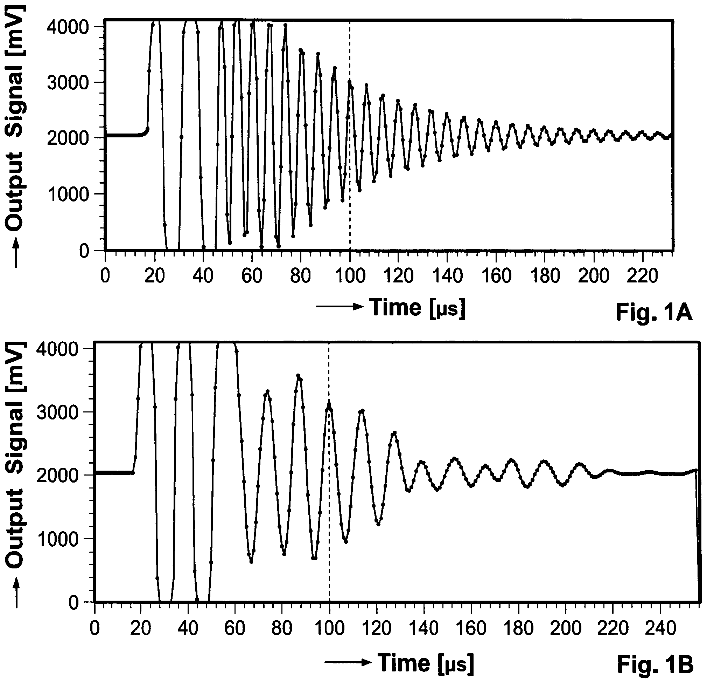

Previous methods include exciting the piezoelectric element at its natural resonant frequency, monitoring the voltage generated by the piezoelectric element and evaluating the recorded voltage signal, as this is for instance shown in US 6639411 B1 or US 6870377 B2. The recorded signal is then compared to a prototype signal, which has been recorded with a properly functioning piezoelectric element using a similar input. Thereby, the comparison of the two signals relies upon analyzing the ringdown of the excitation with a frequency at the transducer's resonance frequency. Fig. 1 shows an example of a voltage signal recorded either with an open circuit (i.e. malfunctioning) piezoelectric element or with a not open circuit (i.e. functioning) piezoelectric element according to a conventional testing method.

DE 103 25 446 B3 teaches excitation of a piezoelectric element by a single voltage pulse, and evaluation of the free oscillation behaviour (ring-down test), in order to detect an open circuit failure. US 2001/039484 A1, US 2011/140685 A1, and EP 2 048 343 A1 disclose essentially the same technique for detecting open circuit state failures in piezoelectric element connections which involves applying individual electrical voltage excitation pulses and monitoring/evaluating the voltages at, and/or the currents running through, the piezoelectric elements.

However, such known methods used for open circuit detection are prone to produce false positives and therefore are not very robust. False detections of open circuits will lead to well-functioning sensors being replaced.

The object of the present invention is to overcome the problems of prior art solutions, in particular the insufficient robustness in detecting open circuits for a piezoelectric element. This object is solved by the subject matter of the independent claims 1 and 12. While previous methods relied upon analyzing the ringdown of an excitation, the present invention is based on looking directly on the excitation itself. This avoids the influence of environmental effects such as the propagation in a medium (e.g. liquid or air) or temperature. Moreover, the present invention uses excitation with a high frequency pulse train instead of the resonance frequency of the piezoelectric element used in previous methods. This caused the piezoelectric transducer to act as a low pass filter. The electrical output signal generated by the piezoelectric element in response to the excitation signal, which is a voltage signal, is monitored during excitation only and is evaluated.

To avoid problems due to small measurement errors which occur under realistic conditions, a constant ε is defined as the smallest number for which the excitation signal only takes values within the intervals [Vₘᵢₙ, Vₘᵢₙ + ε] or [Vₘₐₓ - ε, V_{max]}, where Vₘᵢₙ and Vₘₐₓ are the minimum and the maximum value of the excitation signal, respectively. Alternatively, the constant ε can also be defined as the smallest number for which an output signal, that has been recorded in a pre-test with the piezoelectric element removed from a test circuit, only takes values within the intervals [Vₘᵢₙ, Vₘᵢₙ + ε] or [Vₘₐₓ - ε, V_{max]}, where Vₘᵢₙ and Vₘₐₓ are the minimum and the maximum value of the output signal, respectively.

Generally, the frequency of the pulse train and the constants Vₘᵢₙ, Vₘₐₓ and ε are determined empirically in a number of test runs such that the above requirements are met. Thereby, the test runs are repeated until the probability, that a value for the frequency of the pulse train and the constants Vₘᵢₙ, Vₘₐₓ and ε occurs which is more extreme than the corresponding values from all previous runs, is smaller than a predefined value, e.g. p ≤ 0,01.

The evaluation of the output signal generated by the piezoelectric element includes comparing the monitored electrical output signal with characteristics indicative of an electrical signal generated by a properly functioning piezoelectric element. An example of a necessary and sufficient condition for classifying a piezoelectric element connection as properly functioning is that the output signal takes a significant number of values outside of the vicinity of the minimum and the maximum value of the pulse train ]Vₘᵢₙ + ε, Vₘₐₓ - ε[. Alternatively, another example of a necessary and sufficient condition for classifying a piezoelectric element connection as properly functioning is that the variance of all values of the excitation signal which are higher than Vₘᵢₙ + ε and the variance of all values of the output signal which are higher than Vₘᵢₙ + ε are significantly different. Thereby, the level of significance for classifying a piezoelectric element connection as properly functioning is determined empirically such that the number of false positives and false negatives matches the desired robustness.

In order to execute the above method, a testing apparatus for detecting an open circuit state failure in a piezoelectric element connection is used. The apparatus comprises an exciting unit which is operable to excite the piezoelectric element with an electrical excitation signal, wherein the excitation signal is a pulse train, wherein the frequency of the pulse train is chosen such that the piezoelectric element acts as a low pass filter; a monitoring and evaluating unit which is operable to monitor and evaluate the electrical output signal generated by the piezoelectric element in response to the excitation signal. The monitoring unit is active only when the exciting unit is active. The testing apparatus with the piezoelectric element can be integrated in an electronic device, wherein the electronic device triggers a test run of the testing apparatus, e.g. when the device is booting, to make sure that the piezoelectric element is working properly.

The accompanying drawings are incorporated into and form a part of the specification to illustrate several embodiments of the present invention. These drawings together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form - individually or in different combinations - solutions according to the present invention. Further features and advantages will become apparent from the following more particular description of the various embodiments of the invention, as illustrated in the accompanying drawings, in which like references refer to like elements, and wherein:
**FIG. 1** shows recorded voltage signals according to known methods for detecting whether a circuit in a piezoelectric apparatus is open (Fig. 1 A) or not open (Fig. 1 B);
**FIG. 2** shows recorded voltage signals as used for the method according to the present invention for detecting whether a circuit in a piezoelectric apparatus is open (Fig. 2 A) or not open (Fig. 2 B);
**FIG.** 4 shows a flowchart of a method according to a first embodiment of the present invention;

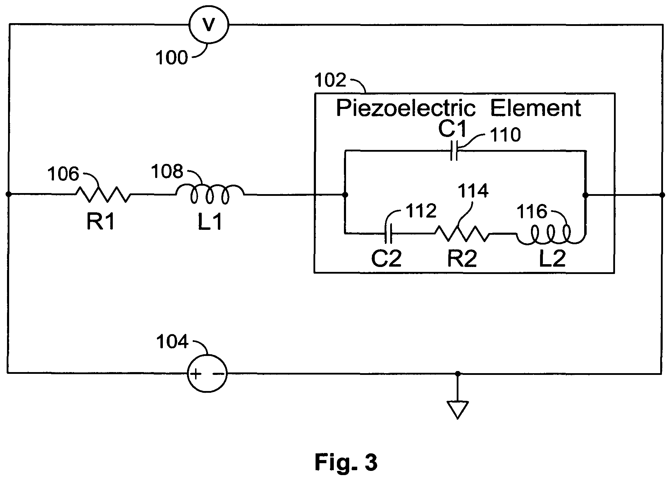

**FIG.** 3 shows a test circuit used for detecting open circuits for a piezoelectric element connection according to the present invention;

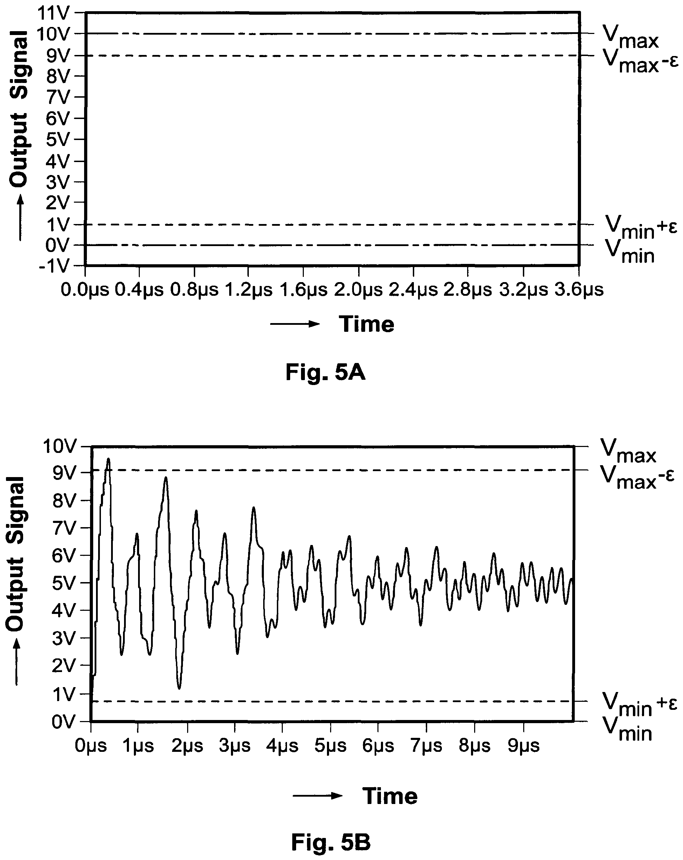

**FIG.** 5 shows recorded voltage signals as used for the method according to the present invention for detecting whether a circuit in a piezoelectric apparatus is open (Fig. 5 A) or not open (Fig. 5 B).

The following embodiments are intended to illustrate the invention for a better understanding. They do not limit the scope of the claims.

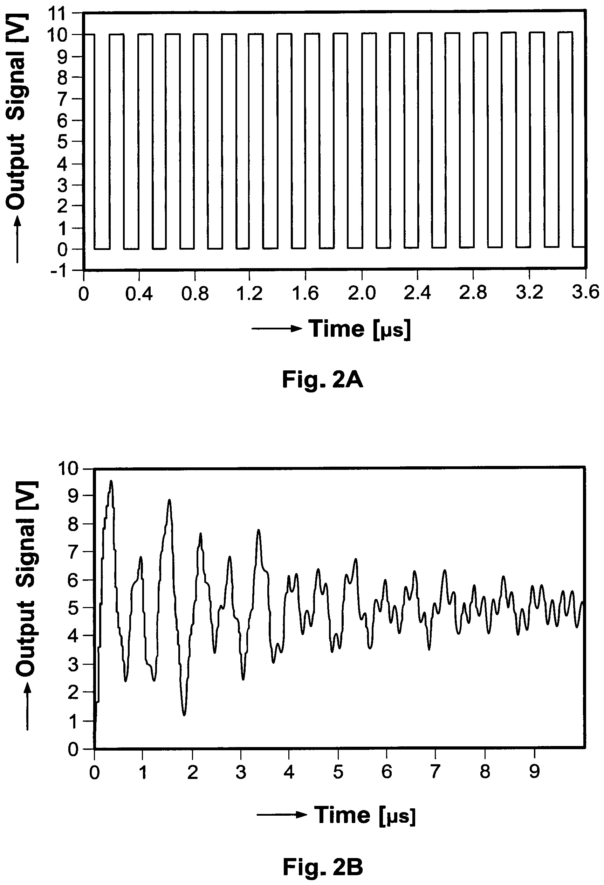

As shown in Fig. 2, the voltage signals in the present invention can be distinguished easily and robustly as compared to previous methods shown in Fig. 1. When there is an open circuit, the piezoelectric element has no influence on the signal recorded during excitation. Therefore, the recorded signal equals the original pulse train used to excite the piezoelectric element. This means that the samples can take two values only, namely either 0 V or the maximal voltage of the pulses. When the circuit is not open, the piezoelectric element acts as a low pass filter and therefore influences the signal recorded during excitation. This means that the samples take values that are higher than 0 V and lower than the maximal voltage of the pulses. By counting the samples taking values between 0 V and the maximal voltage, the open circuit state can be robustly distinguished from the not open circuit state.

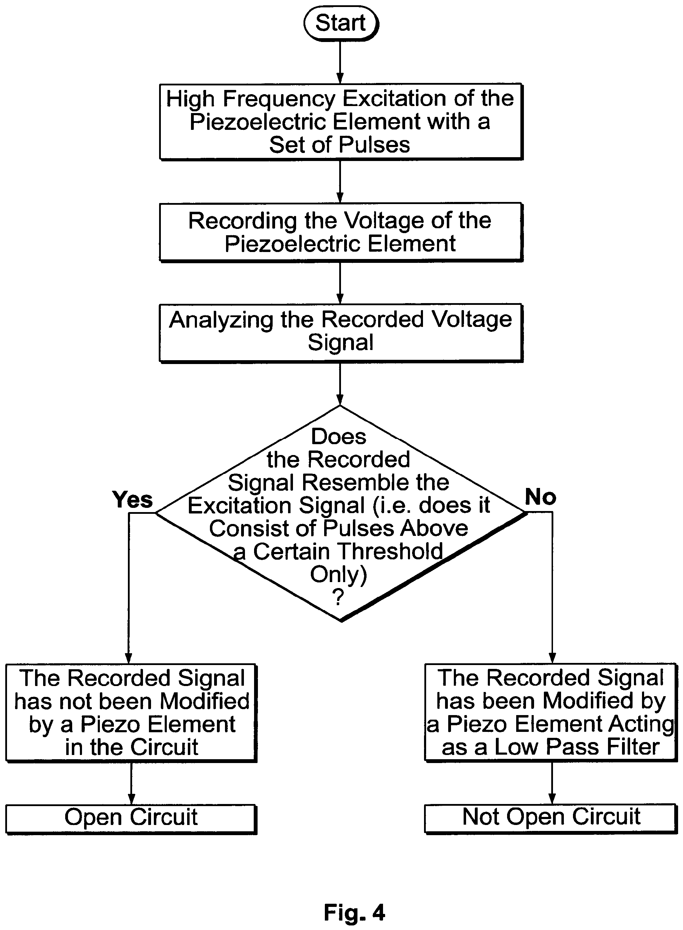

According to an advantageous embodiment of the present invention, a method is provided for detecting an open circuit state failure in a piezoelectric element connectionThe testing set-up comprises a piezoelectric element 102, a resistor 106, an inductor 108, and a voltage source 104 which are connected in series. Using the voltage source 104, the piezoelectric element can be excited with an exciting signal. Moreover, a voltmeter 100 is connected in parallel with the piezoelectric element 102, the resistor 106 and the inductor 108. Using this voltmeter 100, the output signal generated by the piecoelectric element 102 in response to the excitation signal can be measured. Fig. 3 shows the testing set-up in terms of an electrical circuit. The testing method according to the first embodiment is sketched in Fig. 4 in terms of a flow chart.

Specifically, for testing whether or not there is an open circuit state failure, the piezoelectric element 100 is excited with an electrical excitation signal. The excitation signal is a pulse train. By definition the pulse train consists of two values only, namely a minimum value Vₘᵢₙ (usually 0 V) and a maximum value Vₘₐₓ. This means that the excitation signal only takes values in the vicinity of the minimum value [Vₘᵢₙ, Vₘᵢₙ + ε] and in the vicinity of the maximum value [Vₘₐₓ - ε, V_{max]}, where ε is the smallest nonnegative real number for which the excitation signal only takes values within the intervals [Vₘᵢₙ, Vₘᵢₙ + ε] or [Vₘₐₓ - ε, V_{max]}. The constant ε is introduced to make sure that the excitation signal does not take any value within the interval ]Vₘᵢₙ + ε, Vₘₐₓ - ε[, even if a measurement inaccuracy occurs. This is an important characteristic which will help distinguish between an open circuit state and a not open circuit state.

The frequency of the excitation signal is chosen well above the resonance frequency of the piezoelectric element 102. Specifically, the frequency is chosen high enough such that the piezoelectric element 102 cannot follow the excitation signal anymore and therefore acts as a low pass filter. This means that if the piezoelectric element 102 is functional, it modifies the excitation signal such that the output signal significantly differs from the excitation signal. In contrast, when there is an open circuit failure, the piezoelectric element 102 has no influence on the excitation signal and hence the output signal resembles the excitation signal. This characteristic will help distinguish between an open circuit state and a not open circuit state.

Previous methods for detecting open circuit states recorded the output signal both during the excitation and during the following ringdown for further analysis. The disadvantage of this method is that environmental effects such as the propagation in a medium (e.g. liquid or air) or temperature influence the output signal during the ringdown and therefore distort the comparison of excitation and output signal. To avoid such effects, the present embodiment records the output signal only during the excitation without including the ringdown.

When the recording of the output signal is finished, the recorded output signal must be analyzed in order to tell whether or not there is an open circuit state failure in the piezoelectric element connection. Fig. 2 comprises two diagrams, the upper one showing an example of an output signal as it would occur when there is an open circuit state and the lower one showing an example of an output signal as it would occur when there is a not open circuit state. For a better understanding of how the two output signals can be distinguished from each other, we look at Fig. 5 where the connection lines between adjacent samples are omitted in Fig. 5 A. In this figure, the difference between the two signals is obvious.

In case of an open circuit state, the excitation signal is not modified by the piezoelectric element and therefore the output signal resembles the excitation signal. By definition of Vₘᵢₙ, Vₘₐₓ and ε, the excitation signal only takes values in the intervals [Vₘᵢₙ, Vₘᵢₙ + ε] or [Vₘₐₓ - ε, V_{max]}. Since the output signal resembles the excitation signal, this holds true for the output signal as well. In case of a not open circuit state, the excitation signal is modified by the piezoelectric element, the resistor and the inductor which are connected in series. The signal is dampened by the resistor and the inductor, and it is low pass filtered by the piezoelectric element. Therefore, the output signal has a lower amplitude and a different shape compared to the excitation signal. This characteristic can be used for differentiating between the open circuit and the not open circuit state. When the output signal contains a significant number of samples with values in the interval]Vₘᵢₙ + ε, Vₘₐₓ - ε[, then the piezoelectric element connection is considered to be in a not open circuit state in.

The second embodiment equals the first embodiment with one exception: In the first embodiment, the criterion for the circuit state being not open is that the output signal contains a significant number of samples with values in the interval ]Vₘᵢₙ + ε, Vₘₐₓ - ε[. In contrast, in the second embodiment the criterion for the circuit state being not open is that the samples of the output signal with values bigger than Vₘᵢₙ + ε have a variance that significantly exceeds the variance of the samples of the excitation signal with values bigger than Vₘᵢₙ + ε.

The third embodiment equals the first embodiment with one exception: In the first embodiment, Vₘᵢₙ, Vₘₐₓ and ε are chosen such that Vₘᵢₙ, and Vₘₐₓ are the minimum and the maximum of the excitation signal, respectively, and ε is the smallest number for which the excitation signal only takes values within the intervals [Vₘᵢₙ, Vₘᵢₙ + ε] or [Vₘₐₓ - ε, V_{max]}.

In contrast, in the third embodiment the constant ε is defined as the smallest number for which an output signal, that has been recorded in a pre-test with the piezoelectric element removed from the test circuit, only takes values within the intervals [Vₘᵢₙ, Vₘᵢₙ + ε] or [Vₘₐₓ - ε, V_{max]}, where Vₘᵢₙ and Vₘₐₓ are the minimum and the maximum value of the output signal, respectively.

The advantage of using the output signal of the test circuit with an open circuit state to define Vₘᵢₙ, Vₘₐₓ and ε is that the pathway of the output signal is similar to the pathway of the output signal of the not open circuit state, whereas the excitation signal is directly available without passing through a pathway.

### Reference Numerals:

| **Reference Numeral** | **Description** |
|---|---|
| 100 | Output signal |
| 102 | Piezoelectric element |
| 104 | Voltage source |
| 106 | Resistor R1 |
| 108 | Inductor L1 |
| 110 | Capacitor C1 |
| 112 | Capacitor C2 |
| 114 | Resistor R2 |
| 116 | Inductor L2 |

## Claims

1. A method for detecting an open circuit state failure in a piezoelectric element connection, the method comprising:
exciting a piezoelectric element (102) with an electrical excitation signal, and monitoring and evaluating an electrical output signal (100) generated by the piezoelectric element (102) in response to the excitation signal,
**characterised in that** the excitation signal is a pulse train,
wherein a frequency of the pulse train is chosen such that the piezoelectric element (102) acts as a low pass filter.

2. The method of claim 1, wherein the electrical output signal (100) generated by the piezoelectric element (102) is a voltage signal.

3. The method of claim 1 or 2, wherein the electrical output signal (100) generated by the piezoelectric element is monitored during excitation only.

4. The method of claim 3, wherein a constant ε is defined as the smallest number for which the excitation signal only takes values within the intervals [Vₘᵢₙ, Vₘᵢₙ + ε] or [Vₘₐₓ - ε, V_{max]}, where Vₘᵢₙ and Vₘₐₓ are the minimum and the maximum value of the excitation signal, respectively.

5. The method of claim 3, wherein a constant ε is defined as the smallest number for which an output signal, which has been recorded in a calibration step with the piezoelectric element removed from a test circuit, only takes values within the intervals [Vₘᵢₙ, Vₘᵢₙ + ε] or [Vₘₐₓ - ε, V_{max]}, where Vₘᵢₙ and Vₘₐₓ are the minimum and the maximum value of the output signal, respectively.

6. The method according to claim 4 or 5, wherein the frequency of the pulse train and the constants Vₘᵢₙ, Vₘₐₓ and ε are determined empirically in a number of test runs.

7. The method according to claim 6, wherein the test runs are repeated until the probability, that a value for the frequency of the pulse train and the constants Vₘᵢₙ, Vₘₐₓ and ε occurs which is more extreme than the corresponding values from all previous runs, is smaller than a predefined value.

8. The method according to one of the preceding claims, wherein the evaluation of the output signal generated by the piezoelectric element includes comparing the monitored electrical output signal with characteristics indicative of an electrical signal generated by a properly functioning piezoelectric element.

9. The method according to claim 4 or 5, wherein a necessary and sufficient condition for classifying a piezoelectric element connection as properly functioning is that the output signal takes a significant number of values outside of the vicinity of the minimum and the maximum value of the pulse train ]Vₘᵢₙ + ε, Vₘₐₓ - ε[.

10. The method according to claim 4 or 5, wherein a necessary and sufficient condition for classifying a piezoelectric element connection as properly functioning is that the variance of all values of the excitation signal which are higher than Vₘᵢₙ + ε and the variance of all values of the output signal which are higher than Vₘᵢₙ + ε are significantly different.

11. The method according to claim 8 or 9, wherein the level of significance for classifying a piezoelectric element connection as properly functioning is determined empirically such that the number of false positives and false negatives matches the desired robustness.

12. A testing apparatus for detecting an open circuit state failure in a piezoelectric element connection, the apparatus comprising:
an exciting unit which is connectable to a piezoelectric element (102) to be tested and is operable to excite the piezoelectric element (102) with an electrical excitation signal, and
a monitoring and evaluating unit which is operable to monitor and evaluate the electrical output signal (100) generated by the piezoelectric element in response to the excitation signal,
**characterised in that** the excitation signal is a pulse train,
wherein the frequency of the pulse train is chosen such that the piezoelectric element (102) acts as a low pass filter.

13. The testing apparatus according to claim 12, wherein the monitoring unit is active only when the exciting unit is active.

14. The testing apparatus according to claim 12 or 13, wherein the testing apparatus with the piezoelectric element is integrated in an electronic device, wherein the electronic device triggers a test run of the testing apparatus.

## Patentansprüche

1. Verfahren zum Ermitteln eines Stromkreisunterbrechungsfehlers in einer Piezoelementverbindung, wobei das Verfahren umfasst:
Erregen eines Piezoelements (102) mit einem elektrischen Erregungssignal, und
Überwachen und Evaluieren eines elektrischen Ausgangssignals (100), das von dem Piezoelement (102) in Reaktion auf das Erregungssignal erzeugt wird,
**dadurch gekennzeichnet, dass** das Erregungssignal eine Impulskette ist,
wobei eine Frequenz der Impulskette so gewählt wird, dass das Piezoelement (102) als ein Tiefpassfilter wirkt.

2. Verfahren nach Anspruch 1, wobei das elektrische Ausgangssignal (100), das von dem Piezoelement (102) erzeugt wird, ein Spannungssignal ist.

3. Verfahren nach Anspruch 1 oder 2, wobei das elektrische Ausgangssignal (100), das von dem Piezoelement (102) erzeugt wird, nur während der Erregung überwacht wird.

4. Verfahren nach Anspruch 3, wobei eine Konstante ε als die kleinste Zahl definiert ist, für die das Erregungssignal nur Werte innerhalb der Intervalle [Vₘᵢₙ, Vₘᵢₙ + ε] oder [Vₘₐₓ - ε, Vₘₐₓ] annimmt, wobei Vₘᵢₙ und Vₘₐₓ der minimale bzw. der maximale Wert des Erregungssignals sind.

5. Verfahren nach Anspruch 3, wobei eine Konstante ε als die kleinste Zahl definiert ist, für die ein Ausgangssignal, das in einem Kalibrierungsschritt aufgezeichnet wurde, bei dem das Piezoelement aus einer Testschaltung entfernt wurde, nur Werte innerhalb der Intervalle [Vₘᵢₙ, Vₘᵢₙ + ε] oder [Vₘₐₓ - ε, Vₘₐₓ] annimmt, wobei Vₘᵢₙ und Vₘₐₓ der minimale bzw. der maximale Wert des Ausgangssignals sind.

6. Verfahren nach Anspruch 4 oder 5, wobei die Frequenz der Impulskette und die Konstanten Vₘᵢₙ, Vₘₐₓ und ε empirisch in einer Reihe von Testläufen bestimmt werden.

7. Verfahren nach Anspruch 6, wobei die Testläufe so lange wiederholt werden, bis die Wahrscheinlichkeit, dass ein Wert für die Frequenz der Impulskette und die Konstanten Vₘᵢₙ, Vₘₐₓ und ε auftritt, der extremer ist als die entsprechenden Werte aus allen vorherigen Läufen, kleiner als ein vordefinierter Wert ist.

8. Verfahren nach einem der vorhergehenden Ansprüche, wobei die Evaluierung des Ausgangssignals, das durch das Piezoelement erzeugt wird, das Vergleichen des überwachten elektrischen Ausgangssignals mit Eigenschaften beinhaltet, die ein elektrisches Signal anzeigen, das durch ein ordnungsgemäß funktionierendes Piezoelement erzeugt wird.

9. Verfahren nach Anspruch 4 oder 5, wobei eine notwendige und ausreichende Bedingung zum Klassifizieren einer Verbindung eines Piezoelements als ordnungsgemäß funktionierend darin besteht, dass das Ausgangssignal eine signifikante Anzahl von Werten außerhalb der Nähe des minimalen und des maximalen Werts der Impulskette annimmt ]Vₘᵢₙ + ε, Vₘₐₓ - ε[.

10. Verfahren nach Anspruch 4 oder 5, wobei eine notwendige und ausreichende Bedingung zum Klassifizieren einer Verbindung mit Piezoelementen als ordnungsgemäß funktionierend darin besteht, dass die Varianz aller Werte des Erregungssignals, die höher als Vₘᵢₙ + ε sind, und die Varianz aller Werte des Ausgangssignals, die höher als Vₘᵢₙ + ε sind, signifikant unterschiedlich sind.

11. Verfahren nach Anspruch 8 oder 9, wobei das Signifikanzniveau für die Klassifizierung einer Piezoelementverbindung als ordnungsgemäß funktionierend empirisch so bestimmt wird, dass die Anzahl der falsch positiven und falsch negativen Ergebnisse der gewünschten Robustheit entspricht.

12. Prüfvorrichtung zum Ermitteln eines Stromkreisunterbrechungsfehlers in einer Piezoelementverbindung, wobei die Vorrichtung umfasst:
eine Erregungseinheit, die mit einem zu prüfenden Piezoelement (102) verbindbar ist und in Funktion das Piezoelement (102) mit einem elektrischen Erregungssignal erregen kann, und
eine Überwachungs- und Evaluierungseinheit, die in Funktion das elektrische Ausgangssignal (100) überwachen und evaluieren kann, das von dem Piezoelement (102) in Reaktion auf das Erregungssignal erzeugt wird,
**dadurch gekennzeichnet, dass** das Erregungssignal eine Impulskette ist,
wobei die Frequenz der Impulskette so gewählt wird, dass das Piezoelement (102) als ein Tiefpassfilter wirkt.

13. Prüfvorrichtung nach Anspruch 12, wobei die Überwachungseinheit nur dann aktiv ist, wenn die Erregungseinheit aktiv ist.

14. Prüfvorrichtung nach Anspruch 12 oder 13, wobei die Prüfvorrichtung mit dem Piezoelement in eine elektronische Vorrichtung integriert ist, wobei die elektronische Vorrichtung einen Testlauf der Prüfvorrichtung auslöst.

## Revendications

1. Procédé permettant de détecter une défaillance par circuit ouvert dans une connexion d'élément piézoélectrique, le procédé comprenant :
l'excitation d'un élément piézoélectrique (102) avec un signal d'excitation électrique, et la surveillance et l'évaluation d'un signal électrique de sortie (100) généré par l'élément piézoélectrique (102) en réponse au signal d'excitation,
**caractérisé en ce que** le signal d'excitation est un train d'impulsions dans lequel la fréquence du train d'impulsions est choisie de sorte à ce que l'élément piézoélectrique (102) agisse en tant que filtre passe bas.

2. Procédé selon la revendication 1, dans lequel le signal électrique de sortie (100) généré par l'élément piézoélectrique (102) est un signal de tension.

3. Procédé selon la revendication 1 ou la revendication 2, dans lequel le signal électrique de sortie (100) généré par l'élément piézoélectrique n'est surveillé que pendant l'excitation.

4. Procédé selon la revendication 3, dans lequel une constante ε est définie comme étant le nombre le plus petit pour lequel le signal d'excitation ne prend des valeurs que dans les intervalles [Vₘᵢₙ, Vₘᵢₙ + ε] ou [Vₘₐₓ - ε, Vₘₐₓ] où Vₘᵢₙ et Vₘₐₓ représentent respectivement les valeurs minimale et maximale du signal d'excitation.

5. Procédé selon la revendication 3, dans lequel une constante ε est définie comme étant le nombre le plus petit pour lequel le signal de sortie, qui a été enregistré lors d'une étape d'étalonnage alors que l'élément piézoélectrique était éliminé du circuit de test, ne prend des valeurs que dans les intervalles [Vₘᵢₙ, Vₘᵢₙ + ε] ou [Vₘₐₓ - ε, Vₘₐₓ] où Vₘᵢₙ et Vₘₐₓ représentent respectivement la valeur minimale et maximale du signal de sortie.

6. Procédé selon la revendication 4 ou la revendication 5, dans lequel la fréquence du train d'impulsions et les constantes Vₘᵢₙ, Vₘₐₓ et ε sont déterminées empiriquement dans un certain nombre de cycles de test.

7. Procédé selon la revendication 6, dans lequel les cycles de test sont répétés jusqu'à ce que soit inférieure à une valeur prédéterminée la probabilité pour que la valeur de la fréquence du train d'impulsions et des constantes Vₘᵢₙ, Vₘₐₓ et ε apparaisse plus extrême que les valeurs correspondantes de tous les cycles précédents.

8. Procédé selon l'une des revendications précédentes, dans lequel l'évaluation du signal de sortie généré par l'élément piézoélectrique inclut la comparaison du signal électrique de sortie surveillé à des caractéristiques indicatives d'un signal électrique généré par un élément piézoélectrique fonctionnant convenablement.

9. Procédé selon la revendication 4 ou la revendication 5, dans lequel une condition nécessaire et suffisante pour classer une connexion d'élément piézoélectrique comme fonctionnant convenablement est que le signal de sortie comprenne un nombre significatif de valeurs en dehors du voisinage de la valeur minimale et de la valeur maximale du train d'impulsions ]Vₘᵢₙ + ε, Vₘₐₓ - ε[.

10. Procédé selon la revendication 4 ou la revendication 5, dans lequel une condition nécessaire et suffisante pour classer la connexion d'élément piézoélectrique comme fonctionnant convenablement est que la variance de toutes les valeurs du signal d'excitation qui sont supérieures à Vₘᵢₙ + ε et la variance de toutes les valeurs du signal de sortie qui sont supérieures à Vₘᵢₙ + ε soient significativement différentes.

11. Procédé selon la revendication 8 ou la revendication 9, dans lequel le niveau de signification permettant de classer une connexion d'élément piézoélectrique comme fonctionnant convenablement est déterminé empiriquement de sorte à ce que le nombre de faux positifs et de faux négatifs corresponde à la robustesse souhaitée.

12. Appareil de test permettant de détecter une défaillance par circuit ouvert dans une connexion d'élément piézoélectrique, l'appareil comprenant :
une unité d'excitation qui peut être connectée à un élément piézoélectrique (102) à tester et qui peut être mise en œuvre pour exciter l'élément piézoélectrique (102) avec un signal électrique d'excitation, et
une unité de surveillance et d'évaluation qui peut être mise en œuvre pour surveiller et évaluer le signal électrique de sortie (100) généré par l'élément piézoélectrique en réponse au signal d'excitation,
**caractérisé en ce que** le signal d'excitation est un train d'impulsions dans lequel la fréquence du train d'impulsions est choisie de sorte à ce que l'élément piézoélectrique (102) agisse en tant que filtre passe bas.

13. Appareil de test selon la revendication 12, dans lequel l'unité de surveillance n'est active que lorsque l'unité excitation est active.

14. Appareil de test selon la revendication 12 ou la revendication 13, où l'appareil de test comportant l'élément piézoélectrique est intégré dans un dispositif électronique, le dispositif électronique déclenchant un cycle de test de l'appareil de test.
